# DEMANDE DE BREVET EUROPEEN

(11) **EP 0 991 123 A1**
(43) Date de publication de la demande: **05.04.2000**
(21) Numéro de dépôt: 98118595.2
(22) Date de dépôt: 01.10.1998
(51) Int. Cl.: H01L 23/64, H01L 23/48, G06K 19/077, G06K 7/08, H01L 23/498

(54) **Microstructure munie d'une antenne magnétique ou d'un organe de détection magnétique**

(71) Demandeur: EM Microelectronic-Marin SA, 2074 Marin (CH)
(72) Inventeur: Darwish, Mougahed, 2525 Le Landeron (CH); Fuentes, Vincent, 2025 Chez-le-Bart (CH)
(74) Mandataire: Ravenel, Thierry Gérard Louis

(57) **Abrégé**

L'invention concerne une microstructure formée d'un substrat semi-conducteur (2) dans lequel est intégré un circuit électronique et d'une antenne magnétique ou d'un organe de détection magnétique relié à ce circuit électronique et comprenant un enroulement (4) constitué par un fil conducteur (6). Cet enroulement (4) comporte une première partie (8) agencée du côté d'une face supérieure (10) dudit substrat et une deuxième partie (9) agencée du côté d'une face inférieure (11) de ce substrat. Ces première et deuxième parties étant reliées électriquement par au moins une première ouverture (14) effectuée dans ledit substrat entre ses faces supérieure et inférieure.

## Description

La présente invention concerne une microstructure formée d'un substrat semi-conducteur dans lequel est intégré un circuit électronique et comprenant une antenne magnétique ou un organe de détection magnétique relié à ce circuit électronique. Cette antenne magnétique ou cet organe de détection magnétique comprend un enroulement constitué par un fil conducteur.

Selon l'évolution de la technologie des capteurs magnétique et des transpondeurs munis d'une antenne sensible au champ magnétique d'un signal électromagnétique, l'homme du métier cherche à réduire les dimensions de ces capteurs et transpondeurs. Dans cette optique, il a été proposé de former une antenne sous forme d'un enroulement en spirale directement sur une face d'un substrat semi-conducteur au-dessus d'une couche de passivation recouvrant la région active du circuit électronique intégré dans ce substrat semi-conducteur.

Un but de l'invention est de fournir une microstructure avec une antenne magnétique ou un organe de détection magnétique présentant un maximum d'efficacité et de sensibilité pour des dimensions données du substrat semi-conducteur dans lequel est intégré le circuit électronique prévu.

A cet effet, la présente invention concerne une microstructure formée d'un substrat semi-conducteur dans lequel est intégré un circuit électronique et d'une antenne magnétique ou d'un organe de détection magnétique relié à ce circuit électronique et comprenant un enroulement constitué par un fil conducteur, cette microstructure étant caractérisée en ce que cet enroulement comporte une première partie agencée du côté d'une face supérieure dudit substrat et une deuxième partie agencée du côté d'une face inférieure de ce substrat, ces première et deuxième parties étant reliées par une première ouverture effectuée dans ledit substrat entre ses faces supérieure et inférieure.

De préférence, il est prévu une deuxième ouverture effectuée dans le substrat semi-conducteur pour ramener les première et seconde extrémités de ladite deuxième partie dudit enroulement du côté de la face supérieure du substrat semi-conducteur où est agencé le circuit électronique et ses deux plages de connexion électrique à ladite antenne magnétique ou audit organe de détection magnétique, respectivement par lesdites première et deuxième ouvertures.

Il résulte des diverses caractéristiques susmentionnées de l'invention que l'antenne magnétique ou l'organe de détection magnétique présente une efficacité maximale pour des dimensions données d'une microstructure, c'est-à-dire du substrat semi-conducteur la formant. En effet, les deux grandes faces de la microstructure sont utilisées pour avoir un maximum de spires présentant de grandes sections efficaces. Ensuite, le fait de prévoir une ouverture traversant le substrat semi-conducteur permet d'éviter des liaisons électriques par le bord de la microstructure, c est-à-dire par la surface latérale du substrat semi-conducteur, qui sont difficiles à réaliser et augmentent le coût de fabrication.

Selon divers modes de réalisation particuliers de l'invention, il est prévu d'agencer deux ouvertures soit dans la région centrale, soit dans la région périphérique du substrat semi-conducteur.

D'autres avantages et caractéristiques particulières de l'invention seront décrits plus en détail ci-après à l'aide de la description suivante, faite en référence aux dessins ci-annexés dans lesquels :
- Les figures 1a et 1b sont respectivement deux vues en plan des faces supérieure et inférieure d'une microstructure selon l'invention;
- Les figures 2a et 2b, respectivement 3a et 3b sont des vues similaires aux figures 1a et 1b et concernent respectivement des deuxième et troisième modes de réalisation de l'invention;
- La figure 4 est une vue partielle en coupe selon la ligne IV-IV de la figure 3b;
- La figure 5 représente une variante de réalisation de la figure 4;
- La figure 6 est une vue en plan de la face supérieure d'une microstructure selon un quatrième mode de réalisation;
- La figure 7 est une vue partielle en coupe selon la ligne VII-VII de la figure 6;
- Les figures 8a et 8b sont des vues en plan des faces supérieure et inférieure d'une microstructure selon un cinquième mode de réalisation;
- Les figures 9a et 9b représentent schématiquement une ouverture permettant une connexion électrique entre les faces supérieure et inférieure d'un substrat semiconducteur d'une microstructure selon l'invention.
- La figure 10 est une vue similaire à la figure 9b et représente une variante de réalisation où il est prévu des couches de passivation externes disposées de part et d'autre du substrat semi-conducteur;
- la figure 11 représente une variante de réalisation de la figure 9b;
- Les figures 12a et 12b sont des vues en plan des faces supérieure et inférieure d'un sixième mode de réalisation de l'invention.

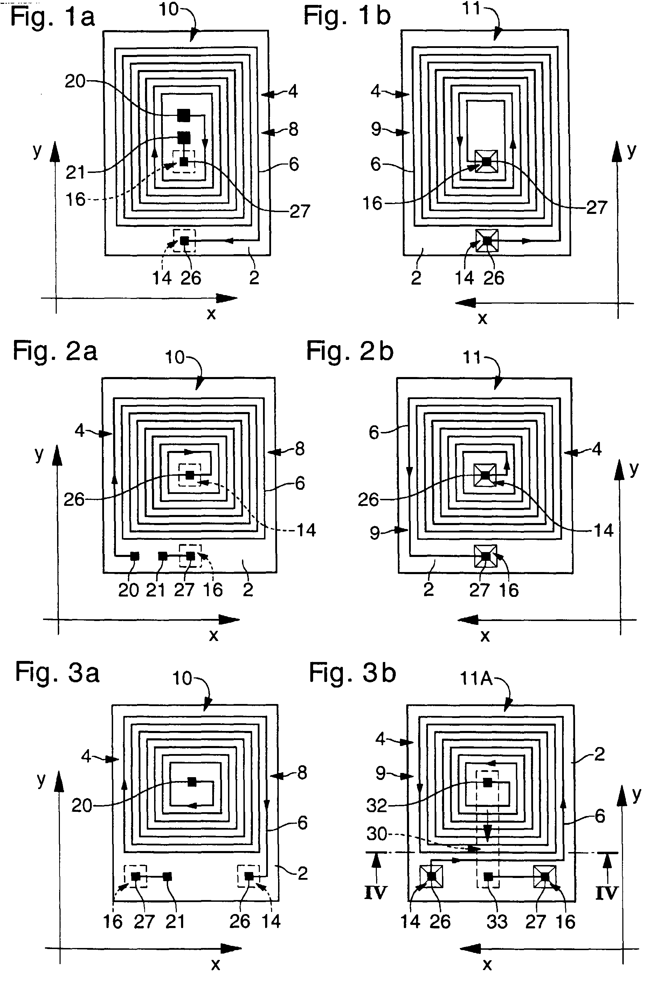

A l'aide des figures 1a et 1b, on décrira ci-après un premier mode de réalisation d'une microstructure selon l'invention. Cette microstructure comprend un substrat semi-conducteur 2 et une antenne magnétique ou un organe de détection magnétique formé pour un enroulement 4 qui est constitué par un fil conducteur 6. Une première partie 8 de l'enroulement 4 est agencée sur la face supérieure 10 du substrat semi-conducteur 2. On notera que le substrat semi-conducteur comprend les couches de passivation et de métallisation conventionnelles prévues en surface du circuit électronique intégré dans ce substrat. Une deuxième partie 9 de l'enroulement 4 est agencée sur la face inférieure 11 du substrat 2.

Afin de relier électriquement les deux parties 8 et 9 de l'enroulement 4, il est prévu selon l'invention d'effectuer une première ouverture 14 dans le substrat 2. La jonction électrique 26 située au centre de l'ouverture 14 sert à relier électriquement les deux parties 8 et 9 de l'enroulement 4. Le fil électrique 6 commence sur la face supérieure 10 par un plot terminal 20 situé dans la région centrale de la face 10. Ensuite, le fil 6 se développe en spirale plane jusqu'à l'ouverture 14 où il s'élargit pour former la jonction électrique 26. Sur la face inférieure 11, le fil 6 définit également une spirale plane en partant de la jonction 26 jusqu'à la jonction électrique 27 située au centre d'une seconde ouverture 16 qui est elle-même située dans la région centrale de la face 11. Un dernier segment du fil 6 relie électriquement la jonction 27 au plot terminal 21 situé dans la région centrale de la face supérieure 10. Les plots terminaux 20 et 21 sont respectivement reliés à deux plages de contact électrique du circuit électronique agencé dans le substrat semiconducteur 2,

L'ouverture 14 effectuée dans le substrat 2 sert à relier électriquement les première et deuxième parties 8 et 9 de l'enroulement 4 agencées respectivement du côté de la face supérieure 10 et du côté de la face inférieure 11 du substrat 2. Ainsi, la première ouverture 14 est une ouverture traversant le substrat 2, ce qui permet d'agencer en son centre une jonction électrique 26 reliant électriquement les faces supérieure 10 et inférieure 11 du substrat 2.

Les références décrites ci-avant ne seront pas à nouveau décrites en détail dans les modes de réalisation décrits ci-après.

Le deuxième mode de réalisation décrit aux figures 2a et 2b se distinguent essentiellement du premier mode de réalisation en ce que les plots terminaux 20 et 21 sont situés dans la région périphérique du substrat semiconducteur 2. Etant donné que les plages de contact électrique pour les bornes ou plots de connexion externe sont généralement situées en périphérie du substrat semiconducteur 2, ce deuxième mode de réalisation est avantageux relativement au premier mode décrit ci-avant.

Aux figures 3a et 3b est représenté un troisième mode de réalisation qui se distingue essentiellement des deux premiers modes de réalisation en ce que les deux ouvertures 14 et 16 sont situées dans la région périphérique du substrat 2. Ainsi, dans la région centrale du substrat 2 n'est prévue aucune ouverture. De ce fait, un design compact du circuit électronique peut être prévu, les deux ouvertures 14 et 16 ne nécessitant pas de prévoir un design particulier autre qu'un design conventionnel prévu notamment dans le cas où l'enroulement 4 n'est agencé que sur la face supérieure 10, comme cela est le cas dans l'art antérieur.

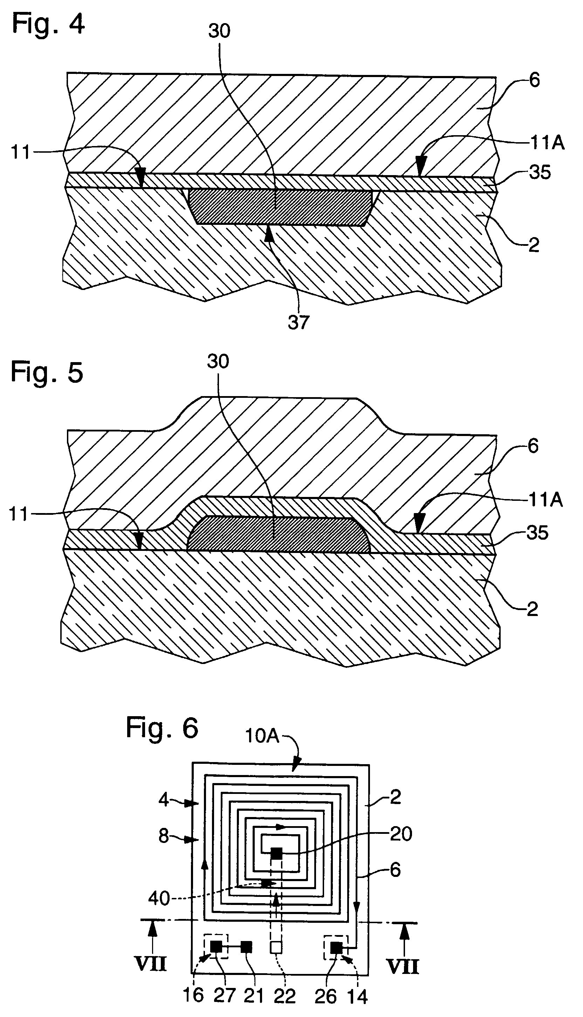

Pour avoir les ouvertures 14 et 16 en périphérie du substrat 2, il est prévu d'agencer au niveau de la face inférieure 11 du substrat une piste conductrice 30 reliant électriquement deux plots 32 et 33 agencés du côté de cette face inférieure 11, au-dessus de la surface 11A d'une couche de passivation 35 recouvrant la face 11 et la piste conductrice 30. Comme représenté à la figure 4, de préférence, la piste conductrice 30 est agencée dans un canal 37 creusé dans la face inférieure 11 du substrat 2.

Toutefois, dans une variante représentée à la figure 5, la piste conductrice 30 peut être agencée en surface de la face inférieure 11, définissant ainsi une bosse rectiligne. De ce fait, le fil conducteur 6 présente une élévation dans la région où il est superposé à la piste conductrice 30.

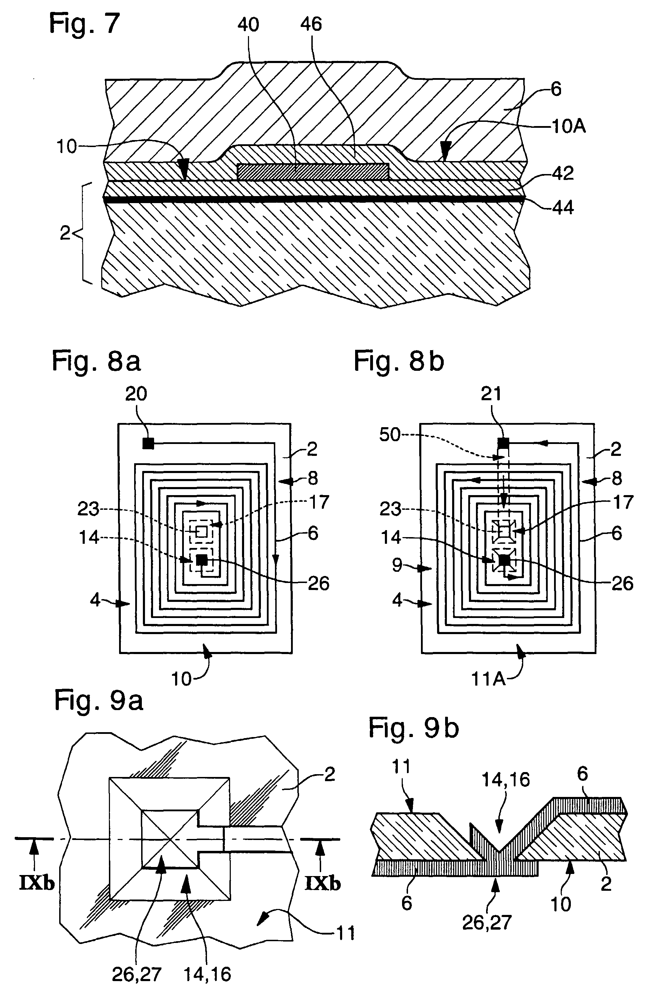

Aux figures 6 et 7 est représenté un quatrième mode de réalisation préféré de l'invention. Ce quatrième mode se distingue essentiellement du troisième mode décrit ciavant en ce que le plot terminal 20 du fil 6, agencé du côté de la face supérieure 10 du substrat 2 dans la région centrale de celui-ci, est relié à une plage de contact électrique 22 située dans la région périphérique du substrat 2 au niveau d'une métallisation 44. Une couche d'isolation (ou de passivation) 42 est prévue au-dessus de la métallisation 44 du circuit électronique intégré dans le substrat 2. A la surface de la couche d'isolation 42 est agencée une piste conductrice 40 dont une extrémité définit une plage de contact électrique avec une plage correspondante de la métallisation 44, alors que l'autre extrémité définit une plage de contact électrique avec le plot terminal 20. La liaison électrique entre le plot 20 et la piste conductrice 40 est réalisée au travers d'une ouverture prévue dans la couche de passivation 46 qui recouvre la piste conductrice 40 et la face 10. La plage 22 définie par l'extrémité de la piste 40 située en périphérie du substrat 2 est reliée à la métallisation 44 et plus particulièrement à la plage correspondante de cette métallisation par une ouverture prévue à cet effet dans la couche d'isolation 42.

On notera que la piste conductrice 40 peut être formée au niveau d'une métallisation ou autre couche en matériau conducteur du circuit électronique servant à établir les interconnexions de celui-ci; ceci en particulier dans une technologie avec plusieurs couches ou niveaux d' interconnexion.

Ainsi, dans ce quatrième mode de réalisation, les deux ouvertures 14 et 16, ainsi que les deux plages de contact électrique du circuit électronique à l'enroulement 4 sont situées dans la région périphérique du substrat semi-conducteur 2. Ceci permet donc un design tout à fait conventionnel pour le circuit électronique intégré dans ce substrat 2.

Un cinquième mode de réalisation est décrit aux figures 8a et 8b, lequel se distingue essentiellement des autres modes décrits ci-avant par le fait que les deux ouvertures 14 et 17 sont toutes deux situées dans la région centrale du substrat 2. La deuxième ouverture 17 présente la particularité de ne pas traverser entièrement le substrat 2, mais de s'arrêter au niveau de la métallisation 44 du circuit électronique intégré dans le substrat 2 du côté de la face supérieure 10. Le fond de l'ouverture 17 effectuée dans le substrat 2 est défini par une plage de contact 23 de la métallisation 44. Du côté de la face inférieure 11 du substrat 2, il est prévu de relier électriquement le plot terminal 21 du fil 6 à la plage de contact 23 par une piste conductrice 50 agencée de manière similaire à la figure 4 ou 5. Cette piste conductrice 50 est recouverte par une couche de passivation 35 dont la surface externe 11A supporte la partie 9 de l'enroulement 4. Ainsi, le fil 6 et la piste conductrice 50 sont isolés électriquement l'un de l'autre.

Ce cinquième mode de réalisation peut être particulièrement avantageux lorsque le substrat semiconducteur 2 est relativement fragile et que des ouvertures situées dans sa région périphérique pourraient engendrer des zones de moindre résistance. Ainsi, pour éviter que le substrat 2 se casse dans sa région périphérique, les deux ouvertures 14 et 17 sont prévues dans la région centrale de ce substrat 2. On notera que l'ouverture 17 dans l'agencement particulier représenté aux figures 8a et 8b peut ne pas traverser entièrement le substrat 2 étant donné que cette ouverture sert à relier une extrémité 21 de l'enroulement 4 à une plage de contact 23 de la métallisation du circuit électronique.

Les figures 9a et 9b montrent schématiquement deux vues respectivement en plan et en coupe d'une ouverture 14, 16 susmentionnée entre les faces inférieure 11 et supérieure 10 du substrat semi-conducteur 2. L'ouverture 14, 16 présente une section tronconique. Elle est obtenue par un micro-usinage anisotrope effectué du côté inférieur 11 du substrat 2. Le fil 6 aboutit à l'intérieur de l'ouverture 14, 16 où il présente de préférence un élargissement pour définir une jonction électrique 26, 27 située dans la région centrale de l'ouverture 14, 16. Du côté de la face supérieure 10, le fil 6 présente une plage initiale recouvrant le trou de l'ouverture dans cette face et définissant également la jonction électrique 26, 27. Un micro-usinage anisotrope engendrant une section tronconique de l'ouverture 14, 16 présente deux avantages. Premièrement, ce micro-usinage peut être relativement rapide. Deuxièmement, la jonction électrique peut être aisément effectuée sans qu'il soit nécessaire de remplir un trou, notamment à parois verticales, d'un matériau électriquement conducteur.

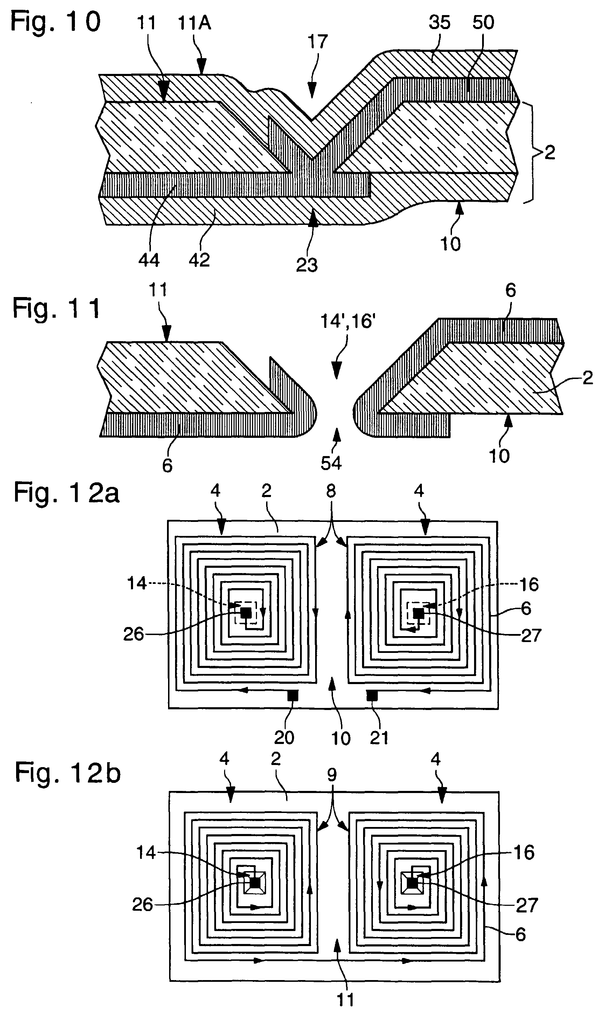

A la figure 10 est représentée l'ouverture 17 du cinquième mode de réalisation représenté aux figures 8a et 8b. On notera que la piste conductrice 50 située du côté de la face inférieure 11 est reliée électriquement, à travers l'ouverture 17 par une jonction électrique 23 similaire aux jonctions 26 et 27 décrites ci-avant, à une plage de contact du niveau de métallisation 44 du circuit intégré. Des couches de passivation inférieure 35 et supérieure 42 sont prévues et recouvrent respectivement la piste conductrice 50 et la métallisation 44.

A la figure 11 est représentée une variante de réalisation des ouvertures 14 et 16 des figures précédentes. Dans cette variante, les ouvertures 14' et 16' se distinguent par le fait qu'un trou 54 reste présent après que la jonction électrique entre les faces inférieure 11 et supérieure 10 ait été réalisée.

Finalement, aux figures 12a et 12b sont représentées respectivement les faces supérieure 10 et inférieure 11 d'un sixième mode de réalisation de l'invention. Ce sixième mode de réalisation se distingue des modes précédents par le fait que les deux ouvertures 14 et 16 sont situées respectivement à deux endroits se trouvant dans la région intérieure du substrat 2 et par le fait que les plots 20 et 21 sont situés dans la région périphérique de ce substrat 2, sans nécessiter de piste conductrice croisant le fil 6 de l'enroulement 4 comme cela est notamment le cas pour le cinquième mode de réalisation décrit ci-avant. L'antenne ou l'organe de détection définit ainsi quatre enroulements secondaires en spirale dont deux sont situés sur la face supérieure 10 et les deux autres sont situés sur la face inférieure 11.

Comme le montre en particulier ce sixième mode de réalisation, plusieurs variantes d'agencement de l'enroulement 4 sur les faces supérieure 10 et inférieure 11 du substrat 2 peuvent être prévues par l'homme du métier sans sortir du cadre de la présente invention.

Afin de disposer d'une antenne magnétique ou d'un organe de détection magnétique sensible et efficace, la hauteur du fil conducteur 6 est prévue relativement élevée, de préférence supérieure à 10 µm. Ceci n'exclut nullement des hauteurs moindres pour certaines applications. La croissance des parties externes des deux parties 8 et 9 du fil conducteur 6 peut avantageusement être effectuée par un dépôt galvanique des deux côtés du substrat semi-conducteur 2.

## Revendications

1. Microstructure formée d'un substrat semiconducteur (2) dans lequel est intégré un circuit électronique et d'une antenne magnétique ou d'un organe de détection magnétique relié à ce circuit électronique et comprenant un enroulement (4) constitué par un fil conducteur (6), caractérisée en ce que cet enroulement (4) comporte une première partie (8) agencée du côté d'une face supérieure (10) dudit substrat et une deuxième partie (9) agencée du côté d'une face inférieure (11) de ce substrat, ces première et deuxième parties étant reliées électriquement par une première ouverture (14) effectuée dans ledit substrat entre ses faces supérieure et inférieure.

2. Microstructure selon la revendication 1, dans laquelle ledit circuit électronique est agencé au niveau de ladite face supérieure (10) dudit substrat (2), caractérisée en ce qu'il est prévu une deuxième ouverture (16) effectuée dans ce substrat entre ses faces supérieure et inférieure (10 et 11), les première et seconde extrémités de ladite deuxième partie (9) dudit enroulement (4) étant ramenées du côté de la face supérieure (10) respectivement par lesdites première et deuxième ouvertures.

3. Microstructure selon la revendication 2, caractérisée en ce que lesdites première et deuxième ouvertures sont situées dans la région périphérique dudit substrat (2).

4. Microstructure selon la revendication 2, caractérisée en ce que lesdites première et deuxième ouvertures (14 et 16) sont situées dans la région centrale dudit substrat semi-conducteur (2), chacune des deux parties (8 et 9) dudit enroulement (4) définissant un enroulement partiel en spirale qui entoure lesdites première et deuxième ouvertures.

5. Microstructure selon la revendication 3 ou 4, caractérisée en ce qu'une piste conductrice (30, 50) formant partiellement la deuxième partie (9) dudit enroulement (4) croise en superposition des spires définies par cette deuxième partie, cette piste étant agencée sous ces spires et isolée de celles-ci par une couche d'isolation ou de passivation.

6. Microstructure selon la revendication 2, caractérisée en ce que chacune des deux parties (8, 9) dudit enroulement (4) définit deux enroulements secondaires en spirale qui sont juxtaposés l'un à l'autre, lesdites première et deuxième ouvertures (14 et 16) étant situées respectivement au centre des deux enroulements secondaires situés sur la face supérieure (10), respectivement sur la face inférieure (11) dudit substrat semi-conducteur (2).

7. Microstructure selon la revendication 6, caractérisée en ce que ledit enroulement (4) est agencé de manière que ses deux extrémités (20, 21) sont agencées du côté de ladite face supérieure (10) et sont situées dans la région périphérique dudit substrat semi-conducteur (2).

8. Microstructure selon l'une des revendications 2 à 6, caractérisée en ce qu'une extrémité (20) dudit enroulement (4) située du côté de ladite face supérieure (10) se trouve dans une région centrale de ladite première partie (8) de cet enroulement, cette extrémité étant connectée à une plage de contact (22), prévue au niveau de la métallisation (44) dudit circuit électronique et située dans une région extérieure à cette première partie, par une piste conductrice (40) agencée entre deux couches d'isolation et/ou de passivation qui sont situées entre ladite métallisation (44) et ladite première partie (8) dudit enroulement (4).

9. Microstructure selon l'une des revendications précédentes, caractérisée en ce que lesdites ouvertures (14, 16, 17) sont obtenues par un micro-usinage anisotrope depuis ladite face inférieure (11) du substrat (2), ces ouvertures présentant une section transversale tronconique, la grande base de cette section étant située au niveau de ladite face inférieure.

10. Microstructure selon l'une des revendications précédentes, caractérisée en ce que ledit fil conducteur (6) dudit enroulement (4) présente une hauteur supérieure à 10 µm, les parties externes des deux parties 8 et 9 dudit enroulement (4) étant obtenues par croissance galvanique.
